# EUROPEAN PATENT APPLICATION

(11) **EP 1 548 822 A1**
(43) Date of publication of application: **29.06.2005**
(21) Application number: 03791244.1
(22) Date of filing: 21.08.2003
(51) Int. Cl.: H01L 21/76, H01L 27/12, H01L 21/304

(54) **METHOD FOR MANUFACTURING SOI WAFER**

(30) Priority: 27.08.2002 JP 2002246422
(71) Applicant: Shin-Etsu Handotai Co., Ltd, Tokyo 100-0005 (JP)
(72) Inventor: Iwabuchi, Miho, Shin-Etsu Handotai Co., Ltd., Nishishiraka wa-gun, Fukushima 961-8061 (JP)
(74) Representative: Grünecker, Kinkeldey, Stockmair & Schwanhäusser
(86) International application number: PCT/JP2003/010559
(87) International publication number: WO 2004/021433

(57) **Abstract**

The present invention provides a method for manufacturing an SOI wafer with high productivity in which generation of voids is suppressed in manufacturing the SOI wafer. The present invention comprises the steps of: forming an insulating layer on at least one wafer of two starting wafers; and adhering the one wafer to the other wafer without using an adhesive; wherein a PV value of a surface of the insulating layer is 1.5 nm or less.

## Description

### Technical Field:

The present invention relates to a method for manufacturing an SOI (Silicon on Insulator) wafer constituted of an SOI layer, an insulating layer and a support substrate, and particularly, to a method for manufacturing an SOI wafer by means of a bonding method (an adhering method).

### Background Art:

In recent years, an integration level in an integrated circuit has greatly increased, which has been accompanied by stricter required conditions imposed on a processing precision such as flatness or smoothness of a mirror-polished wafer surface. In addition, in order to achieve an integrated circuit higher in performance, reliability and product yield, not only a higher mechanical precision, but also better electric characteristics have been required. Especially, an SOI wafer, which is an ideal dielectric isolation substrate, has been used in applications to high frequency and high-speed devices mainly related to mobile communication equipment and medical equipment and further great increase in demand therefor is expected in the future.

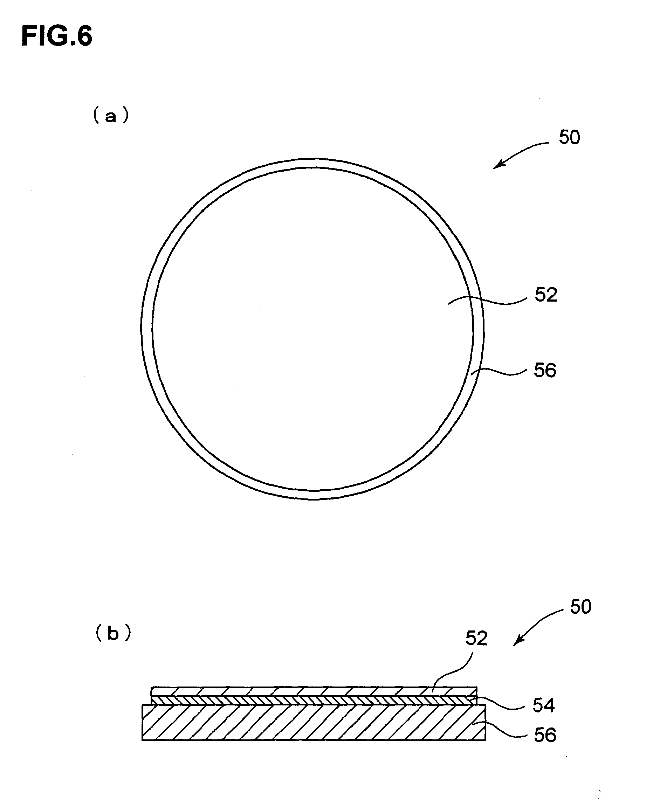

An SOI wafer 50, as shown in Fig. 6, has a structure in which an SOI layer 52 (also referred to as a semiconductor layer or an active layer) for forming an element such as a single crystal silicon layer is formed on an insulating layer 54 (also referred to as a buried oxide (BOX) film layer or simply an oxide film layer) such as a silicon oxide film. The insulating layer 54 is formed on a support substrate 56 (also referred to as a substrate layer) and the SOI wafer 50 has a structure in which the insulating layer 54 and the SOI layer 52 are sequentially formed on the support substrate 56.

As conventional methods for manufacturing an SOI wafer 50 having the SOI structure in which the SOI layer 52 and the support substrate 56 are made of, for example, silicon and the insulating layer 54 is made of, for example, a silicon oxide film, there are exemplified an SIMOX (Separation by implanted oxygen) method in which oxygen ions are implanted into a silicon single crystal at a high concentration and thereafter the single crystal is subjected to heat treatment at a high temperature to form an oxide film thereon; and a bonding method (an adhering method) in which two mirror-polished wafers are bonded with each other without the use of an adhesive, followed by processing one of the bonded wafers into a thin film.

Since the SIMOX method can controllably determine a film thickness of an active layer portion (an SOI layer) 52 to serve as a device active region by an acceleration voltage in oxygen ion implantation, there is an advantage that a thin active layer high in film thickness uniformity can be easily obtained, whereas there have remained many issues problems of reliability of a buried oxide (BOX) film (an insulating layer) 54, crystallinity in an active layer, and others.

On the other hand, a wafer bonding method is carried out in such a way that an oxide film (an insulating layer) 54 is formed on at least one of two single crystal silicon mirror-polished wafers, then both wafers are adhered with each other without using an adhesive, then the adhered wafers are subjected to heat treatment (usually at a temperature in the range of 1100°C to 1200°C) to strengthen bonding therebetween and thereafter one of the wafers is thinned into a thin film by grinding or wet etching, followed by mirror-polishing the surface of the thin film so as to obtain an SOI layer 52; which leads to advantages that reliability of the buried oxide film (an insulating layer) 54 is high and crystallinity of the SOI layer is also good. However, the thus adhered SOI wafer 50 is subjected to mechanical processing such as grinding or polishing into a thin film, and hence the obtained SOI layer 52 have limitations in its film thickness and uniformity thereof.

As a method for manufacturing an SOI wafer, it has very recently started to pay attention to a method for manufacturing an SOI wafer by bonding of an ion implanted wafer and separating of the wafer. This method is also referred to as an ion implantation separation method, which is such a technique that two silicon wafers are provided to be ready for use; an insulating layer is formed on at least one wafer (a bond wafer); hydrogen ions or rare gas ions are implanted onto an upper surface of the bond wafer; a micro-bubble layer is formed in the interior of the bond wafer, the surface onto which the ions are implanted is contacted and adhered with the other silicon wafer (a base wafer) through the insulating layer; thereafter by applying heat treatment to the adhered wafers, a part of the bond wafer is separated with the micro-bubble layer as a cleavage plane for the rest of the bond wafer to become a thin film; and heat treatment is further applied to the rest of the adhered wafers to strongly bond the bond wafer in the form of a thin film to the base wafer through the insulating layer interposed therebetween to thereby obtain an SOI wafer (see JP-A No. 5-211128). According to this method, the cleavage plane is a good mirror-polished surface and the SOI wafer having high uniformity of film thickness of the SOI layer can be obtained with relative ease.

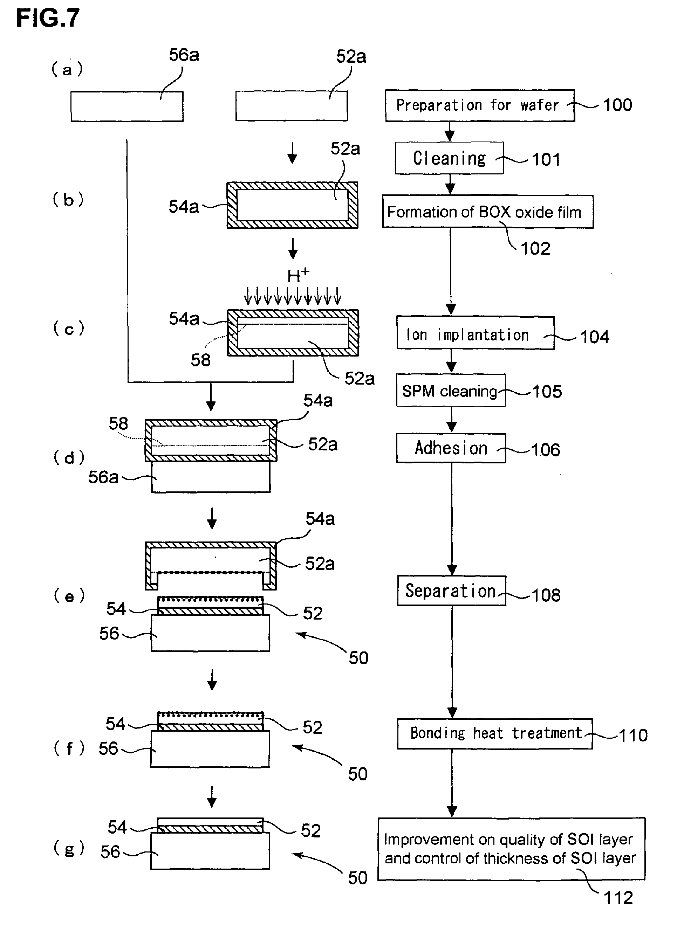

In FIG. 7, further detailed description will be given of the ion implantation separation method showing one example of a set of main steps thereof. There are provided to be ready for use two starting wafers, that is, a base wafer 56a serving as a support substrate 56 and a bond wafer 52a from which an SOI layer 52 is formed [FIG. 7(a), step 100]. As these wafers, for example, mirror-polished silicon single crystal wafers are used. These wafers are subjected to cleaning treatment when required (step 101).

An oxide film 54a serving as a buried oxide (BOX) film (an insulating layer) at a later step is formed on a surface of the bond wafer 52a [FIG. 7(b), step 102]. This step is carried out as follows. For execution of this step, for example, thermal oxidation is applied on the bond wafer 52a of a silicon single crystal wafer to form a silicon oxide film on the bond wafer 52a.

Then, hydrogen ions (or rare gas ions) are implanted into the bond wafer 52a through the oxide film 54a to form a micro-bubble layer (an enclosed layer) 58 [FIG. 7(c), step 104].

Thereafter, chemical cleaning may be carried out using a H₂SO₄-H₂O₂ mixed solution or the like (step 105). The H₂SO₄-H₂O₂ mixed solution has been known with an abbreviation of SPM (Sulfuric Acid-Hydrogen Peroxide Mixture) and is a cleaning solution for removal of organic contaminants.

Then, the bond wafer 52a in which the micro-bubble layer (the enclosed layer) 58 is formed is brought into contact with the base wafer 56a at room temperature through the oxide film 54a on the surface of the bond wafer 52a into which the ion implantation has been performed [FIG. 7(d), step 106].

Then, by applying heat treatment (separation heat treatment) at a temperature of 500°C or higher, a part of the bond wafer 52a is separated at the enclosed layer 58 and the rest of the bond wafer 52a stands in the form of a thin film [FIG. 7(e), step 108]. Next, by applying bonding heat treatment [FIG. 7(f), step 110], the bond wafer 52a in the form of the thin film and the base wafer 56a are strongly bonded with each other through the oxide film 54a interposed therebetween, whereby a wafer 50 having an SOI structure is manufactured.

The SOI wafer manufactured using the adhering method has, at this stage, a sectional structure in which the insulating film (layer) 54 and the SOI layer 52 are stacked sequentially on one main surface of the support substrate 56. Regions called polishing sags are present along the outer periphery of each of the two mirror polished wafers to be adhered and the regions are removed because bonding thereof becomes insufficient; therefore, the insulating layer 54 and the SOI layer 52 are generally smaller in diameter than the support substrate 56 by a value of the order of several mm.

In addition, another step may be adopted as shown in FIG. 7(g), in which a surface of the SOI layer 52 of the wafer having the SOI structure is modified and the thickness of the SOI layer 52 is controlled (step 112). For example, since damage caused by hydrogen ion implantation remains on a surface (a separation surface) of the SOI layer 52 of the SOI wafer 50 having the obtained SOI structure, the damage layer is removed by applying polishing with a small polishing stock removal usually called touch polishing. In replacement of touch polishing, by performing heat treatment in an argon gas atmosphere, sacrifice oxidation treatment in which thermal oxidation and removal of an oxide film are conducted to reduce the film thickness of the SOI layer 52 or a combination thereof in a proper way, an SOI wafer 50 having a damage free thin film SOI layer 52 may be manufactured.

A method for manufacturing wafers to be used as starting materials of an SOI wafer includes: a slicing step of slicing a single crystal rod (ingot) generally produced in a single crystal producing apparatus to obtain a thin disk-like wafer; a chamfering step of chamfering a peripheral edge portion of the wafer obtained through the slicing step to prevent cracking or chipping of the wafer; a lapping step of flattening the chamfered wafer; an etching step of removing processing deformation remaining on the surface of the chamfered and lapped wafer; a stock removal mirror polishing step of polishing roughly the surface of the etched wafer in contact with a polishing cloth; a final mirror polishing step of mirror polishing finally the surface of the wafer subjected to the stock removal mirror polishing; and a final cleaning step of cleaning the final mirror polished wafer to remove a polishing agent or dust particles deposited thereon. The above-described wafer manufacturing process shows basic steps thereof, and sometimes other steps such as a heat treatment step may be added, or the same step may be divided into multiple sub-steps, or the step sequence may be changed to manufacture the wafer.

In fabrication of devices using an SOI wafer, there has been a problem of reducing a product yield of the devices. The present inventor has seriously investigated a cause of the problem and has concluded that a reduction in product yield is caused by generation of a defect called a void (B) in the SOI layer 52 and an insulating layer (an oxide film) 54 of the SOI wafer 50. The void means a state where a hole is formed in the SOI layer or the insulating layer.

### Disclosure of the Invention:

The present invention has been made in light of the problem described above and it is a main object of the present invention to provide a method for manufacturing an SOI wafer with high productivity in which generation of voids is suppressed in manufacturing the SOI wafer.

In order to solve the above issue, the present inventor has made serious investigations and found that quality of a starting wafer used as a bond wafer of an SOI wafer affects generation of voids. It has become clear that a pit present on a surface of a bond wafer is especially problematic. Various kinds of defects have been conventionally observed on a silicon wafer used as a starting material of a bond wafer, among which COP (Crystal Originated Particle) has been famous as a typical defect. While the COP is a kind of a defect in the shape of a pit, it has become clear that the COP does not affect the generation of voids so much. The present inventor has further made serious investigations on the problem and found that the void is easily generated when a large pit such as a lap scratch is present on the bond wafer or even small pits are present as a group thereon. That is, it has been found that there is especially problematic a pit cluster where plural micro pits collect together.

While the pit cluster has had no generally accepted clear definition, it means a defect where micro pits collect together in the shape of an island and a size of a collection of the micro pits is comparatively large, for example, 0.5 µm or more. In the present specification, the pit cluster is defined as a defect where micro pits collect together in the shape of an island and a size thereof is 0.5 µm or more. It is conceivable that the pit cluster may be mainly generated by heavy metal contamination in a polishing step, during storage in a pit bath after polishing and in a cleaning and drying step.

If an oxide film is formed on the bond wafer on which such a pit cluster is present, the following inconveniences occur: degradation in characteristics of the oxide film, abnormal growth of the oxide film, degradation in flatness (uniformity) of the oxide film itself or especially degradation in surface roughness of an insulating layer. The bond wafer having the above inconveniences is adhered to a base wafer; therefore, there is weak adhesion between the pit cluster and the oxide film where the surface roughness of the insulating layer is poor, which conceivably leads to a void.

Accordingly, a method for manufacturing an SOI wafer of the present invention comprises: forming an insulating layer on at least one wafer (a bond wafer) of two starting wafers; and adhering the bond wafer to the other wafer (a base wafer) without using an adhesive, wherein surface roughness of the insulating layer is controlled to a prescribed value or less. It is especially required that a PV (Peak to Valley) value of surface irregularities of the insulating layer (the oxide film) is 1.5 nm or less, that is, there is no portion having a PV value more than 1.5 nm when evaluating the value in an area of 10 µm x 10 µm. If a bond wafer and a base wafer are adhered with each other with an insulating layer in such a surface roughness state, generation of voids can be greatly reduced.

It is preferable that a PV value of a surface of an insulating layer is 1.5 nm or less by using a wafer having no pit cluster as a bond wafer. The wafer having no pit cluster is a wafer where there are not observed (detected) on the surface of the wafer such defects as observed in the form of a collection of micro-defects each of which is not in the form of a projection when evaluating defects each having 0.08 µm or more by the use of, for example, a laser microscope with a confocal optical system. The laser microscope with a confocal optical system can detect whether each of defects is in the form of a projection or a pit (a recess) with bright and dark patterns of the defects depending on how to detect them, and directly observe a distribution of defects and others, with the result that a defect such as a pit cluster is easily identified. The pit cluster is observed as a collection where tens or more of micro-defects each in the shape of a pit having a size of the order of 0.08 to 0.2 µm collect, and a size thereof is 0.5 µm or more, for example, on the order of 1 µm to 10 µm and in the largest case, on the order of tens of µm.

A wafer on which no pit cluster is detected (or present) means a wafer on which no collection of micro defects as described above is present, and the number of the collections each having a large size of 0.5 µm or more on a surface (a front surface) of the wafer is zero. It is conceivable that if a pit cluster is present, a surface of a BOX oxide film (an insulating layer) is roughened and an adhesion at a site of the pit cluster is reduced to thereby easily generate a void. It is conceivable that the pit having a size of 0.5 µm or less in an independent state has little effect on surface roughness of the insulating layer and generation of voids, but the pits in a densely collected state, that is, in a state of a pit cluster, lead to surface roughness of the BOX oxide film and generation of voids.

A method for adhering two wafers to be used as starting wafers in the present invention preferably comprises the steps of: forming an insulating layer (an oxide film) on at least one wafer (a bond wafer) of two starting wafers; implanting hydrogen ions or rare gas ions through an upper surface of the bond wafer to form a micro-bubble layer in the interior of the bond wafer; thereafter bringing the surface of the bond wafer through which the ions have been implanted into contact with the other wafer (a base wafer) through the insulating layer (the oxide film) interposed therebetween; then separating a part of the bond wafer with the micro-bubble layer as a cleavage plane by applying heat treatment for the rest thereof to become a thin film; and bonding strongly the bond wafer in the form of a thin film to the base wafer through the insulating layer interposed therebetween by applying further heat treatment.

A cause of generation of a void is conceivable in the following way: That is, when a pit cluster formed by densely collecting small pits is present on a wafer, an oxide film formed on the wafer allows deterioration in characteristics of the oxide film, flatness (uniformity) of the oxide film itself and especially surface roughness of the oxide film; the base wafer is adhered to the wafer in the above state, which leads to weakness in adhesion of the oxide film with the base wafer at a site where a surface of the oxide film is roughened, resulting in generation of a void at the site. Therefore, generation of such a void is an issue specific to a manufacturing method for an SOI wafer according to the bonding method (the adhering method) and it is conceivable that no generation of a void in such a manner described above occurs in a method such as the SIMOX method. Especially, in a method in which hydrogen ions are implanted into a wafer to thereby form a micro-bubble layer in the interior of the wafer, followed by adhesion and separation, generation of voids is conspicuous, and in a case where there is used for manufacturing an SOI wafer a bond wafer on which no pit cluster described above is present, that is, a bond wafer having an oxide film less in surface roughness when a BOX oxide film is formed, an effect of suppressing generation of voids is great.

Incidentally, starting wafers are selected and used in the following manner: Wafers are inspected on the presence or absence of a pit cluster on a surface of each wafer, and wafers having no pit cluster are selected and employed as the staring wafers each having no pit cluster. No specific limitation is placed on the methods for inspecting a pit cluster on a wafer surface and defects each having a size of 0.08 µm or more are preferably evaluated by the use of, for example, a laser microscope with a confocal optical system, in which the presence or absence of a collection of micro-defects is inspected. As another method, a pit cluster can be evaluated by the use of an atomic force microscopy (AFM) or the like.

If the above-described selection is applied to wafers and the selected wafers are used as starting wafers to manufacture an SOI wafer, generation of voids can be reduced.

Incidentally, in order to manufacture wafers free of a pit cluster, it is preferable that wafers mirror polished in an environment where a heavy metal concentration is 10 ppb or less are used as bond wafers.

A cause of generation of a pit cluster is conceivably due to heavy metal contamination mainly in a process from a polishing step to a stage of storage in a pit bath after polishing and in a cleaning and drying step, and if mirror polishing is conducted while contamination in the process is controlled, wafers less of pit clusters can be manufactured, the wafers being preferably used as starting wafers for manufacturing SOI wafers. The less heavy metal contamination is more preferable, and a total content of heavy metals such as Cu and Ni is preferably 10 ppb or less and more preferably 1 ppb or less.

### Brief Description of the Drawings:

FIG. 1 is a flowchart showing an example of the order of steps in a method for manufacturing an SOI wafer of the present invention together with schematic views.
FIG. 2 is a map showing results of observation by a laser microscope with a confocal optical system on a surface of a bond wafer after cleaning in Experimental Example 1.
FIG. 3 shows results of observation by AFM on a surface of a bond wafer before and after BOX oxidation in Experimental Example 1, wherein the part (a)(1) is a schematic view showing a pit cluster on a surface of a bond wafer before BOX oxidation, the part (a)(2) is a graph showing depth profiles of respective pits, the part (b)(1) is a schematic view showing abnormal growth of an oxide film on a surface of a bond wafer after BOX oxidation and the part (b)(2) is a graph showing height profiles of respective abnormal growth portions.
FIG. 4 shows photographs indicating results of observation at the same point by a laser microscope with a confocal optical system before and after adhesion in Experimental Example 1, wherein the part (a) shows surface states of an oxide film at sites (1) (2) on a surface of a bond wafer after formation of a BOX oxide film and before adhesion, and the part (b) shows enlarged surface states of an SOI layer after adhesion at the portions corresponding to the sites (1) (2).
FIG. 5 is a flowchart showing the order of steps in a method for manufacturing an SOI wafer of Experimental Example 1 together with schematic views.
FIG. 6 shows descriptive views indicating an example of a structure of an SOI wafer, wherein the part (a) is a descriptive top plan view and the part (b) is a descriptive sectional view.
FIG.7 is a flowchart showing the order of steps in a conventional method for manufacturing an SOI wafer together with schematic views.

### Best Mode for Carrying Out the Invention:

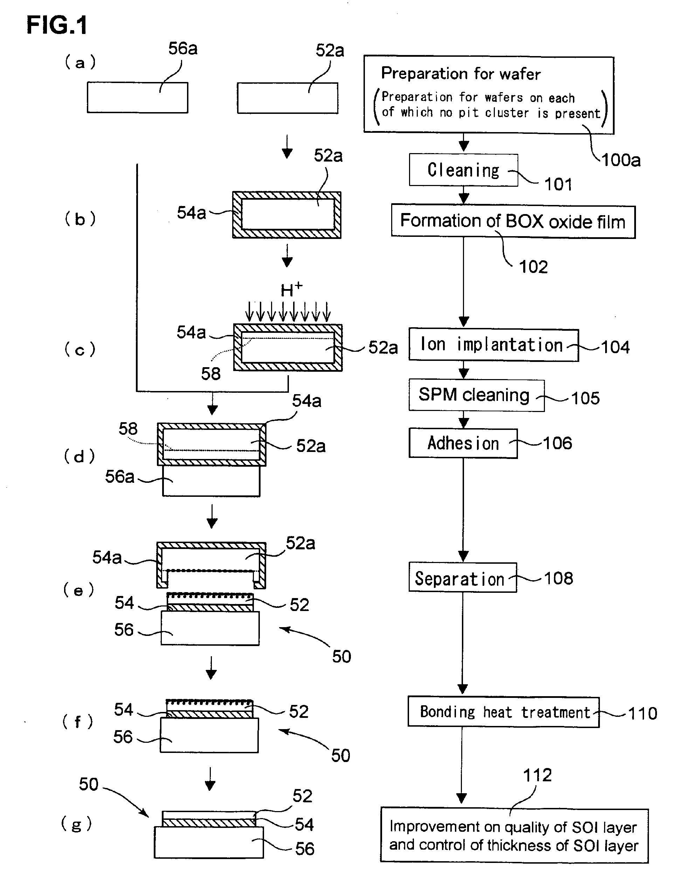

Description will be given of an embodiment of a method for manufacturing an SOI wafer according to the present invention below based on FIG. 1 and it is needless to say that the example shown in the figure is presented by way of illustration only and various modifications or variations can be implemented as far as not departing from the technical concept of the present invention.

FIG. 1 is a flowchart showing an example of the order of steps in a method for manufacturing an SOI wafer of the present invention together with schematic views.

The same or similar members in FIG. 1 as or to those in FIG. 7 are indicated with the same reference numerals.

Since the flowchart of manufacturing an SOI wafer of the present invention shown in FIG.1 is the same as the conventional flowchart of manufacturing an SOI wafer in the basic order of steps, second description of the same steps is omitted and description will be given of different points therebetween only.

The method of the present invention comprises the steps of: forming an insulating layer 54a on at least one wafer (a bond wafer) 52a of two starting wafers, that is, the bond wafer 52a and a base wafer 56a; and adhering the bond wafer 52a and the base wafer 56a with each other without using an adhesive to manufacture an SOI wafer 50, wherein the base wafer 56a and the bond wafer 52a are adhered with each other such that there is present no surface irregularity exceeding a PV value of 1.5 nm on a surface of the insulating layer 54a, in other words, the PV value (evaluated in an area of 10 µm x 10 µm) is 1.5 nm or less.

In the present invention, in order to form the insulating film 54a having a low PV value, attention is directed to quality of a silicon single crystal wafer to be used as the bond wafer 52a; there is used a wafer having no pit cluster as the bond wafer 52a [FIG. 1(a), step 100a], whereby the insulating layer 54a having a low PV value can be formed [FIG. 1(a), step 100a].

The wafers having no pit cluster are obtained in such a way that wafers are inspected on the presence or absence of a pit cluster on a surface of each wafer, and wafers having no pit cluster are selected. Such a wafer having no pit cluster is manufactured with special attention to heavy metal contamination after a polishing step. For example, a wafer subjected to mirror polishing and storage after the polishing in an environment where a heavy metal concentration is 10 ppb or less is used as the bond wafer. For example, after completion of the polishing, a polished wafer may be immersed in pure water or the like for storage during transferring to the next step, wherein heavy metal quantity or the like in the water for the use of the storage is controlled.

In the method of the present invention, the order of the step of forming a BOX oxide film (step 102) and the subsequent steps is perfectly the same as that in the conventional method shown in Fig. 7, whereas in the obtained SOI wafers 50 generation of voids is greatly reduced and thereby the SOI wafers 50 good in product yield can be manufactured.

### Examples

While further concrete description will be given of the present invention, showing examples below, it is needless to say that the examples are presented by way of illustration and should not be construed by way of limitation.

### (Experimental Example 1)

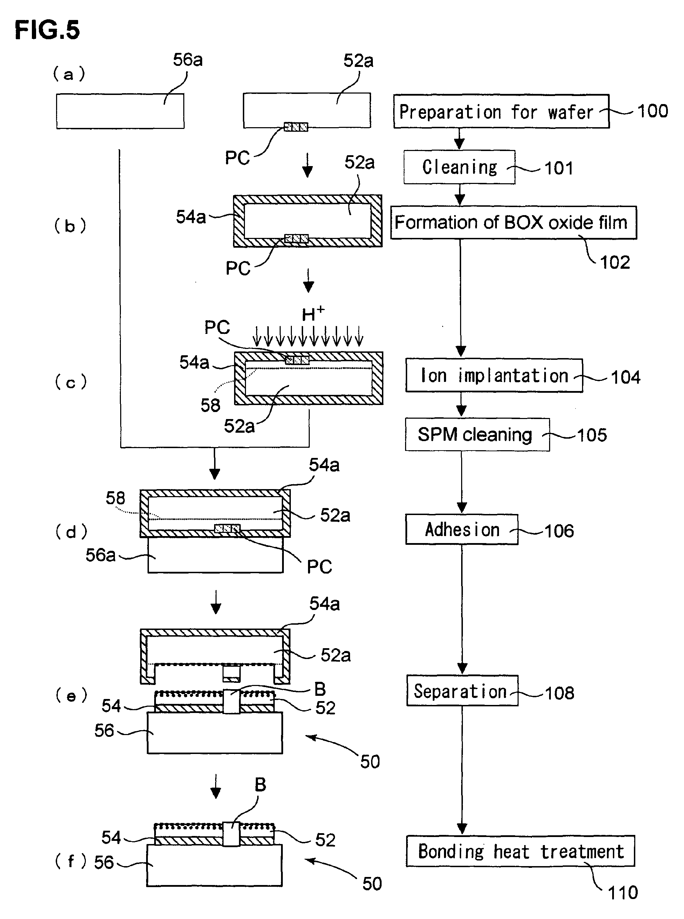

Description will be given of a case where an SOI wafer was manufactured using a bond wafer having pit clusters as Experimental Example 1. FIG.5 is a flowchart showing the order of steps in Experimental Example 1 together with schematic views. At first, there were prepared as a base wafer 56a and a bond wafer 52a p-type mirror polished silicon wafers each having a diameter of 300 mm, a < 100 > orientation and a resistivity of 10 Ω·cm manufactured from an ingot grown by a CZ method [FIG. 5(a), step 100]. Then, these wafers were cleaned (step 101).

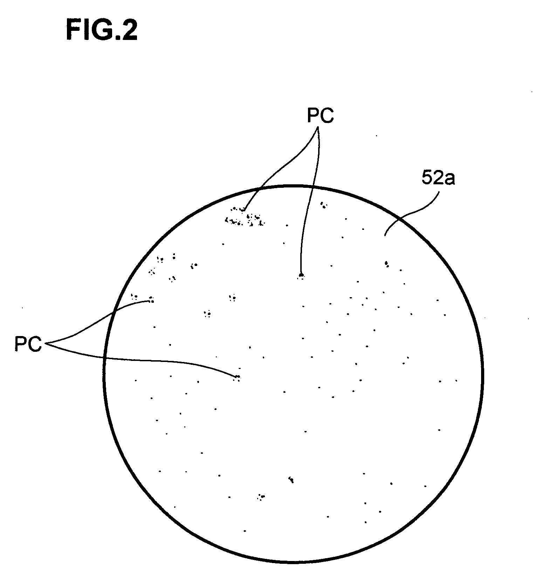

The cleaned bond wafer 52a was observed on the presence or absence of pit clusters by a laser microscope with a confocal optical system (with a trade name of MAGICS, manufactured by Lasertec Corporation). As shown in Fig.2, about twenty pit clusters (PC) were observed on a surface of the bond wafer 52a. FIG. 2 is a schematic map view on the entire wafer showing results of observation by the laser microscope with the confocal optical system on the surface of the bond wafer 52a after cleaning. Though an enlarged view of each pit cluster (PC) was not shown, each of the pit clusters was a defect where tens or more of micro defects each in the shape of a pit having a size of the order in the range of 0.08 to 0.2 µm collect to form a collection each having a size of 0.5 µm or more, for example, of the order of 1 µm to 10 µm.

A BOX oxide film 54a having a thickness of 150 nm was formed on a surface of the bond wafer 52a on which the pit clusters (PC) are present [FIG. 5(b), step 102]. Then, hydrogen ions were implanted to form an enclosed layer 58 [FIG. 5(c), step 104]. Then, an SPM cleaning was carried out (step 105).

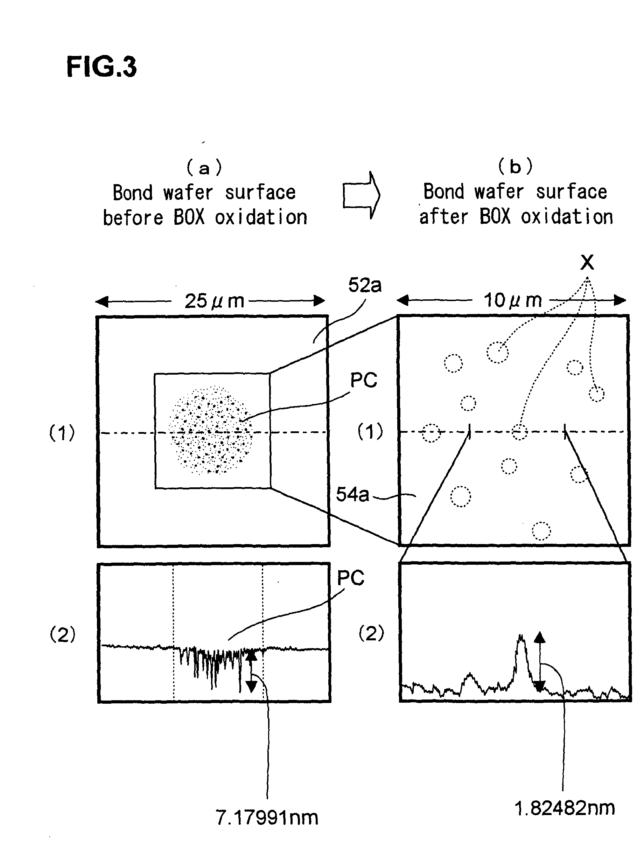

At this stage, the oxide film 54a at a site where the pit cluster was present was observed by AFM (with a trade name of SPA360, manufactured by Seiko Instruments Inc.). FIG. 3 shows results of observation by AFM on the surface of the bond wafer before and after BOX oxidation, wherein the part (a)(1) is a schematic view showing a pit cluster on a surface of a bond wafer before BOX oxidation, the part (a)(2) is a graph showing depth profiles of respective pits, the part (b)(1) is a schematic view showing abnormal growth of an oxide film on a surface of a bond wafer after BOX oxidation and the part (b)(2) is a graph showing height profiles of respective abnormal growth portions. As shown in FIG. 3, plural abnormal growth portions (X) in the oxide film (portions indicated with symbols O in FIG. 3(b)(1)) were present at the sites where pit clusters (PC) were present and surface roughness was observed there. When observing a height profile of a part of abnormal growth portions (X) of FIG. 3 (b), it was found that a projection with a height of the order of a PV value of 1.8 nm was abnormally grown as shown in FIG. 3(b)(2). The other projections abnormally grown were more than virtually 1.5 nm in height.

Next, the surface of the bond wafer 52a through which ions were implanted and the base wafer 56a were brought into contact with each other at room temperature [FIG. 5(d), step 106]. Then, separating heat treatment was applied thereto in a nitrogen atmosphere at 500°C for 30 min to separate a part of the bond wafer 52a to thereby make the bond wafer 52 into a thin film, with the result that there was obtained an SOI layer having a thickness of about 250 nm [FIG. 5(e), step 108].

Thereafter, bonding heat treatment was applied thereto in a nitrogen atmosphere at 1100°C for 2 hr to strongly bond the SOI layer 52 to the base wafer 56. As a result, there was manufactured a wafer 50 having an SOI structure [FIG. 5(f), step 110].

Next, in order to remove surface roughness and damage of the SOI layer 52, heat treatment was applied further thereto in an argon atmosphere. This heat treatment was carried out in an argon gas atmosphere at 1200°C for 1 hr with a vertical heater type heat treatment apparatus (a batch furnace). With this heat treatment, damage caused by ion implantation and surface roughness of the SOI layer 52 were improved to some extent. Then, in order to further improve the surface of the SOI layer, the SOI layer 52 was polished with a CMP polishing apparatus. A polishing stock removal in this polishing was on the order of 40 nm. By sacrifice-oxidizing the SOI layer 52, silicon on the SOI layer 52 was oxidized to form an oxide film, and the oxide film was treated with hydrofluoric acid, with the result that there was manufactured a thin film SOI wafer 50 having the SOI layer 52 with a thickness of about 150 nm.

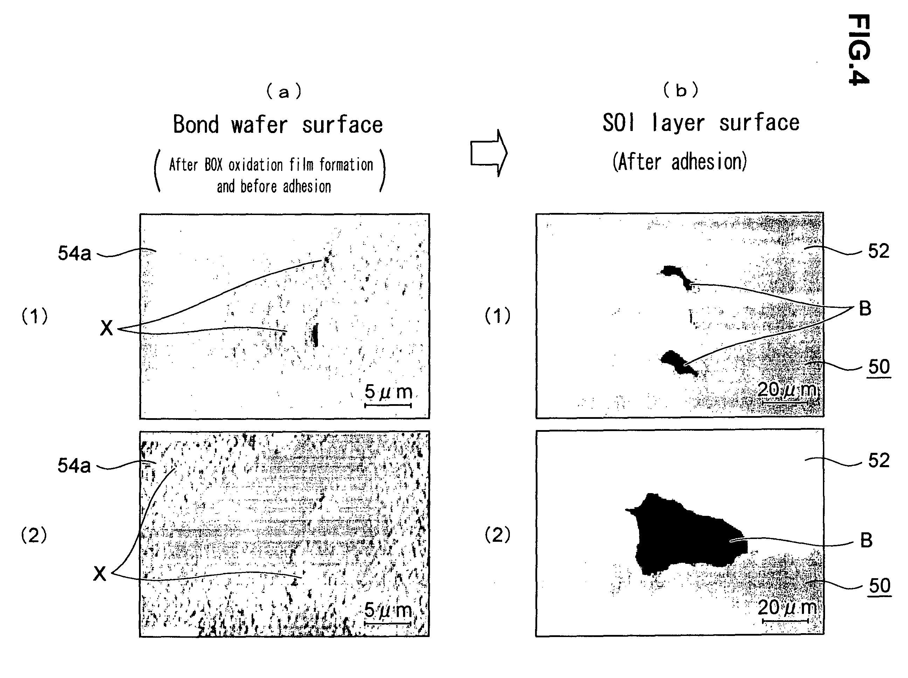

After the SOI wafer 50 was manufactured in the manner described above, as a result of observation at the same point where a pit cluster was found, a void (B) as shown in FIG. 4 was observed. FIG. 4 shows photographs indicating results of observation at the same point by a laser microscope with a confocal optical system before and after adhesion, wherein the part (a) shows surface states of an oxide film at sites (1) (2) on a surface of a bond wafer after formation of a BOX oxide film and before adhesion, and the part (b) shows enlarged surface states of an SOI layer after adhesion at the portions corresponding to the sites (1) (2). For example, as shown in FIG. 4(a), roughening (abnormal growth) of the oxide film occurred at a site where a pit cluster was present and, as obvious from FIG. 4(b), a void (B) having a diameter of 20 µm or more was observed at the site.

### (Example 1)

Description will be given of an example where an SOI wafer was manufactured using a bond wafer free of a pit cluster in the order of steps of a method of the present invention shown in FIG. 1. At first, there were prepared as a base wafer 56a and a bond wafer 52a p-type mirror polished silicon wafers each having a diameter of 300 mm, a < 100 > orientation and a resistivity of 10 Ω·cm manufactured from an ingot grown by a CZ method [FIG. 1(a), step 100a]. Then, these wafers were cleaned (step 101).

Wafers were manufactured in the same manufacturing conditions as in Experimental Example 1 and inspected by a laser microscope with a confocal optical system. After the inspection, a wafer free of a pit cluster on a surface thereof was selected and employed as the bond wafer 52a.

A BOX oxide film 54a having a thickness of 150 nm was formed on a surface of the bond wafer 52a [FIG. 1(b), step 102]. Then, hydrogen ions were implanted to form an enclosed layer 58 [FIG. 1(c), step 104]. Then, an SPM cleaning was carried out (step 105).

Next, the surface of the bond wafer 52a through which ions were implanted and the base wafer 56a were brought into contact with each other at room temperature [FIG. 1(d), step 106]. Then, separating heat treatment was applied thereto in a nitrogen atmosphere at 500°C for 30 min to separate a part of the bond wafer 52a to thereby make the bond wafer 52 into a thin film, with the result that there was obtained an SOI layer having a thickness of about 250 nm [FIG. 1(e), step 108]. Thereafter, bonding heat treatment was applied thereto in a nitrogen atmosphere at 1100°C for 2 hr to strongly bond the SOI layer 52 to the base wafer 56. As a result, there was manufactured a wafer 50 having an SOI structure [FIG. 1(f), step 110].

Next, in order to remove surface roughness and damage of the SOI layer 52, heat treatment was applied further thereto in an argon atmosphere. This heat treatment was carried out in an argon gas atmosphere at 1200°C for 1 hr with a vertical heater type heat treatment apparatus (a batch furnace). With this heat treatment, damage caused by ion implantation and surface roughness of the SOI layer 52 were improved to some extent. Then, in order to further improve the surface of the SOI layer, the SOI layer 52 was polished with a CMP polishing apparatus. A polishing stock removal in this polishing was on the order of 40 nm. By sacrifice-oxidizing the SOI layer 52, silicon on the SOI layer 52 was oxidized to form an oxide film, and the oxide film was treated with hydrofluoric acid, with the result that there was manufactured a thin film SOI wafer 50 having the SOI layer 52 with a thickness of about 150 nm [FIG. 1(g), step 112].

The obtained SOI wafer was observed on voids thereof. The observation on voids was carried out by a laser microscope with a confocal optical system. As a result, no void was observed. Such an SOI wafer was employed in fabrication of devices to thereby increase a product yield.

The present invention is not limited to the embodiments described above. The above embodiments are presented by way of illustration only and any of modifications or alterations thereof are included in the technical scope of the present invention as far as those have substantially the same construction as the technical concept stated in the appended claims of the present invention and exert an action and effect similar to those of the present invention.

For example, the manufacturing process shown in the example is presented by way of illustration only. As far as the method for manufacturing an SOI wafer includes an adhering step, the present invention may adopt proper changes of the steps depending on purposes, that is, addition of various steps such as cleaning and heat treatment other than the above steps, a partial change for the order of the steps, and partial omission for the steps such as CMP polishing where quality of an SOI layer is improved or a thickness thereof is adjusted.

### Capability of Exploitation in Industry:

As described above, according to the method of the present invention, since an SOI wafer is manufactured using a wafer free of a pit cluster as a bond wafer, generation of voids is greatly reduced, with the result that it is possible to manufacture an SOI wafer with a good product yield and high productivity.

## Claims

1. A method for manufacturing an SOI wafer comprising the steps of:
forming an insulating layer on at least one wafer of two starting wafers; and
adhering the one wafer to the other wafer without using an adhesive,
wherein a PV value of a surface of the insulating layer is 1.5 nm or less.

2. The method for manufacturing an SOI wafer according to claim 1,
wherein the PV value of the surface of the insulating layer is controlled to be 1.5 nm or less by using a wafer free of a pit cluster thereon as the one wafer.

3. The method for manufacturing an SOI wafer according to claim 1 or 2, comprising the steps of:
forming an insulating layer on at least one wafer of two starting wafers;
implanting hydrogen ions or rare gas ions through an upper surface of the one wafer to form a micro-bubble layer in the interior of the one wafer; thereafter
bringing the surface of the one wafer through which the ions have been implanted into contact with the other wafer through the insulating layer interposed therebetween; then
separating a part of the one wafer with the micro-bubble layer as a cleavage plane by applying heat treatment for the rest thereof to become a thin film; and
bonding strongly the one wafer in the form of a thin film to the other wafer through the insulating layer interposed therebetween by applying further heat treatment.

4. The method for manufacturing an SOI wafer according to any of claims 1 to 3, wherein wafers are inspected on the presence or absence of a pit cluster on a surface of each wafer, wafers having no pit cluster thereon are selected and the selected wafers are employed as starting wafers.

5. The method for manufacturing an SOI wafer according to any of claims 1 to 4, wherein wafers mirror polished in an environment where a heavy metal concentration is 10 ppb or less are used as the starting wafers.
